(19) Europäisches Patentamt
European Patent Office
Office européen des brevets

(11) Publication number: 0 504 724 A1

# (12) EUROPEAN PATENT APPLICATION

(21) Application number: 92104167.9

(51) Int. Cl.5: G03F 7/022

(22) Date of filing: 11.03.92

(30) Priority: 14.03.91 JP 49444/91

(43) Date of publication of application:
23.09.92 Bulletin 92/39

(84) Designated Contracting States:
BE DE FR GB IT NL

(71) Applicant: SUMITOMO CHEMICAL COMPANY, LIMITED
5-33, Kitahama 4-chome Chuo-ku
Osaka(JP)

(72) Inventor: Uetani, Yasunori
2-10-3-350, Sonehigashino-cho
Toyonaka-shi, Osaka-fu(JP)
Inventor: Tomioka, Jun
c/o Sumitomokagaku Mefu-ryo 410go, 2-14-7, Mefu
Takarazuka-shi, Hyogo-ken(JP)
Inventor: Doi, Yasunori
1-9-1-409, Tamagawa
Takatsuki-shi, Osaka-fu(JP)
Inventor: Nakanishi, Hirotoshi
1-8-14, Yamazaki, Shimamoto-cho
Mishima-gun, Osaka-fu(JP)
Inventor: Hanawa, Ryotaro
2-1-325, Kuwata-cho
Ibaraki-shi, Osaka-fu(JP)
Inventor: Ida, Ayako
3-10-14, Takenodai, Nishi-ku
Kobe-shi, Hyogo-ken(JP)

(74) Representative: Vossius & Partner
Siebertstrasse 4 P.O. Box 86 07 67
W-8000 München 86(DE)

## (54) Positive resist composition.

(57) A positive resist composition which contains, in admixture, an alkali-soluble resin and at least one quinone diazide sulfonate of a phenol compound of the formula:

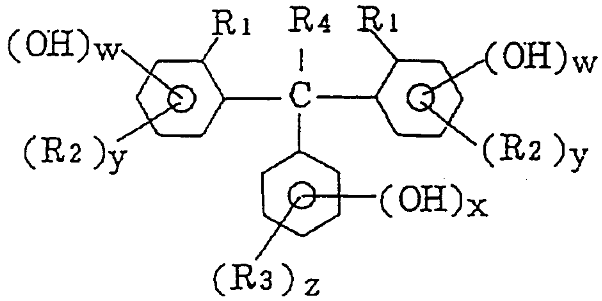

(I)

in which $R_1$ and $R_2$ are independently an alkyl group, an alkoxy group, a carboxyl group or a halogen atom; $R_3$ is a hydrogen atom, an alkyl group, an alkoxy group, a carboxyl group or a halogen atom; $R_4$ is a hydrogen atom, an alkyl group or an aryl group; and w, x, y and z are independently 0, 1, 2 or 3, provided that the sum of w and x is at least 1 or a phenol compound of the formula:

EP 0 504 724 A1

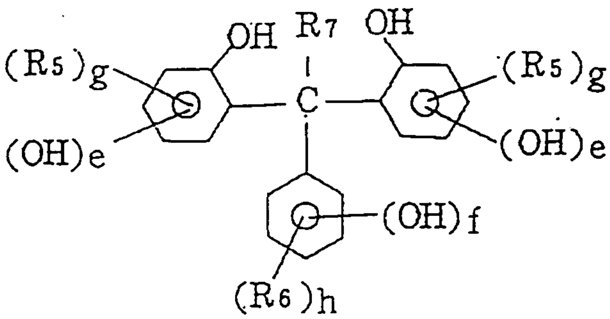

(II)

in which $R_5$ is an alkyl group, an alkoxy group, a carboxyl group or a halogen atom; $R_6$ is a hydrogen atom, an alkyl. group, an alkoxy group, a carboxyl group or a halogen atom; $R_7$ is a hydrogen atom, an alkyl group or an aryl group; and e, f, g and h are independently 0, 1, 2 or 3, which composition has a high $\gamma$-value and a high film thickness retention.

The present invention relates to a positive resist composition having a high γ-value and a high film thickness retention.

A composition containing a compound having a quinone diazide group and an alkali-soluble resin finds use as a positive resist, because upon exposure to light having a wavelength of 300 to 500 nm, the quinone diazide group decomposes to form a carboxyl group whereby the originally alkali-insoluble composition becomes alkali-soluble. The positive resist composition has much better resolution than a negative resist composition and is used in the production of integrated circuits such as IC or LSI.

Recently, particularly with integrated circuits, miniaturization has proceeded with a rise in the integration level, which results in demands for formation of patterns of submicron order, more excellent resolution and higher γ-value. However, a resist composition comprising a conventional quinone diazide compound and a conventional alkali-soluble resin has a limit in increase of the γ-value.

For example, if an amount of the quinone diazide compound is increased to improve the γ-value, serious problems such as deterioration of sensitivity and increase of residues after developing arise. Therefore, the improvement of the γ-value is limited.

To achieve good resolution, not only the high γ-value but also a high film thickness retention are preferred.

An object of the present invention is to provide a positive resist composition which has a high γ-value and also a high film thickness retention.

According to a first aspect of the present invention, there is provided a positive resist composition which comprises, in admixture, an alkali-soluble resin and at least one quinone diazide sulfonate of a phenol compound of the formula:

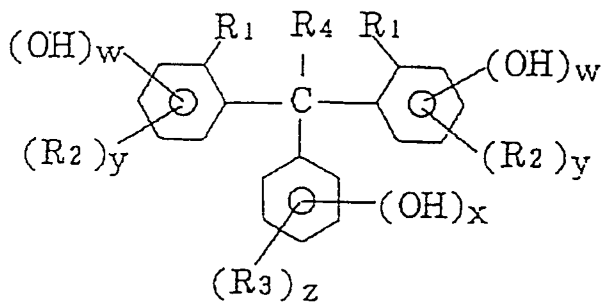

(I)

wherein $R_1$ and $R_2$ are independently an alkyl group, an alkoxy group, a carboxyl group or a halogen atom; $R_3$ is a hydrogen atom, an alkyl group, an alkoxy group, a carboxyl group or a halogen atom; $R_4$ is a hydrogen atom, an alkyl group or an aryl group; and w, x, y and z are independently 0, 1, 2 or 3, provided that the sum of w and x is at least 1.

According to a second aspect of the present invention, there is provided a positive resist composition comprising, in admixture, an alkali-soluble resin and at least one quinone diazide sulfonate of a phenol compound of the formula:

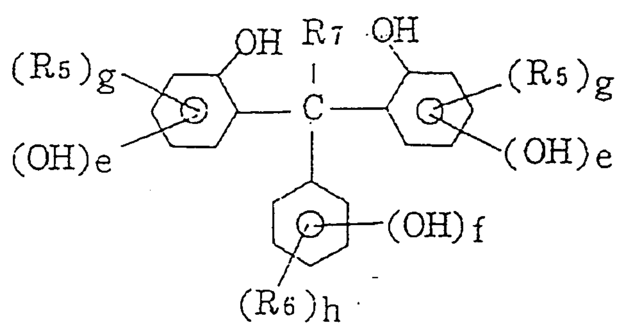

(II)

wherein $R_5$ is an alkyl group, an alkoxy group, a carboxyl group or a halogen atom; $R_6$ is a hydrogen atom, an alkyl group, an alkoxy group, a carboxyl group or a halogen atom; $R_7$ is a hydrogen atom, an alkyl group or an aryl group; and e, f, g and h are independently 0, 1, 2 or 3.

Herein, preferably, the alkyl group has 1 to 5 carbon atoms, the alkoxy group has 1 to 5 carbon atoms,

and the aryl group has 6 to 12 carbon atoms. The halogen atom may be chlorine, bromine and iodine.

In the formula (I), $R_1$ or $R_2$ is preferably a $C_1$-$C_5$ alkyl group, a methoxy group, an ethoxy group or a carboxyl group. $R_3$ is preferably a hydrogen atom, a $C_1$-$C_5$ alkyl group, a methoxy group, an ethoxy group or a carboxyl group. $R_4$ is preferably a hydrogen atom, a $C_1$-$C_5$ alkyl group or an aryl group such as a phenyl group and a naphthyl group.

Preferred examples of the phenol compound (I) are a compound of the formula:

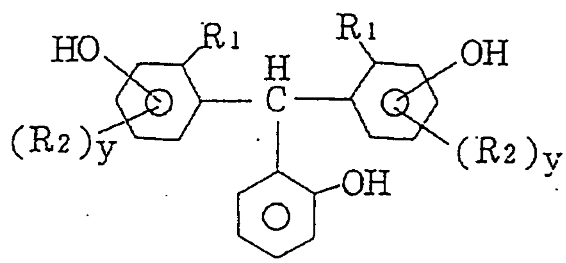

wherein $R_1$, $R_2$ and y are the same as defined above. More preferred examples of the compound (I) are as follows:

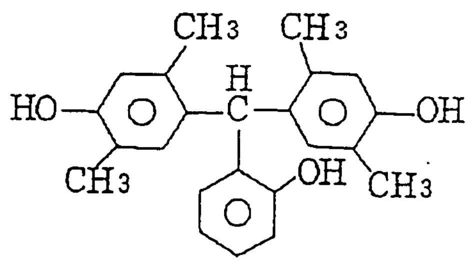

,

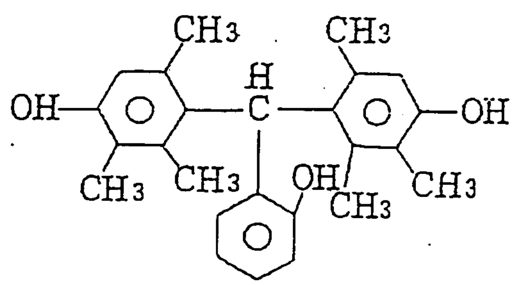

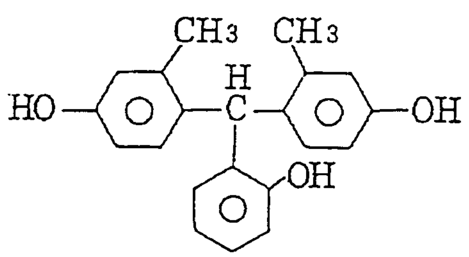

,

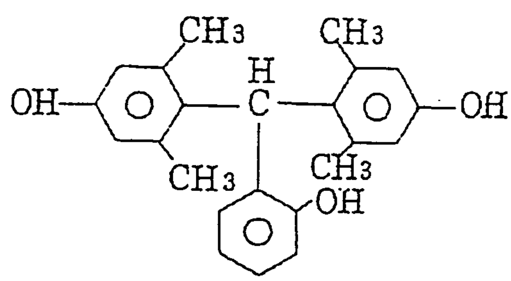

In the formula (II), $R_5$ is preferably a $C_1$-$C_5$ alkyl group, a methoxy group, an ethoxy group or a carboxyl group. $R_6$ is preferably a hydrogen atom, a $C_1$-$C_5$ alkyl group, a methoxy group, an ethoxy group or a carboxyl group. $R_7$ is preferably a hydrogen atom, a $C_1$-$C_5$ alkyl group or an aryl group such as a phenyl group and a naphthyl group.

Preferred examples of the phenol compound (II) are a compound of the formula:

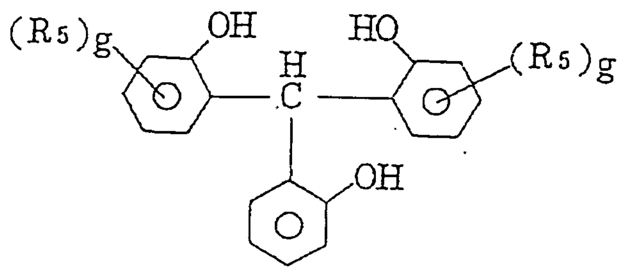

wherein $R_5$ and g are the same as defined above. More preferred examples of the compound (II) are as follows:

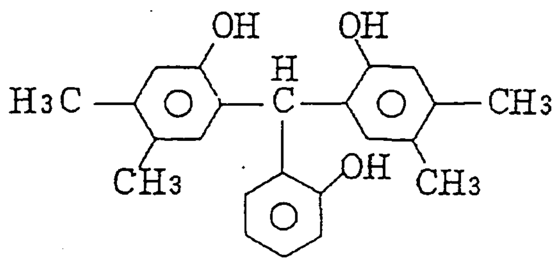

,

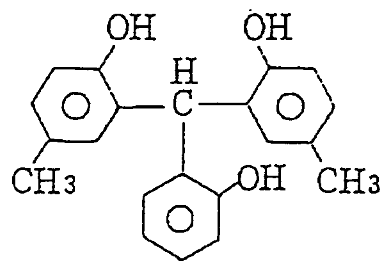

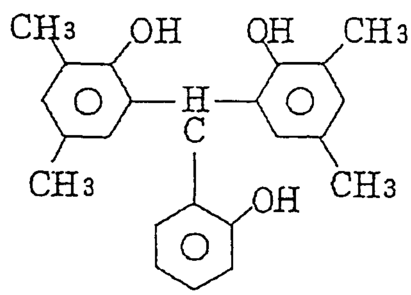

The phenol compound of the formula (I) or (II) may be synthesized through a condensation reaction of at least one phenol such as phenol or cresol with a carbonyl compound in the presence of an acid catalyst.

The quinone diazide sulfonate of the phenol compound may be prepared by a per se conventional method. For example, the quinone diazide sulfonate is prepared by a condensation reaction of the phenol compound with naphthoquinone diazide sulfonyl halide or benzoquionone diazide sulfonyl halide in the presence of a weak alkali such as sodium carbonate.

The quinone diazide sulfonates of the phenol compound may be used alone or in combination.

To the positive resist composition of the present invention, a quinone diazide sulfonate of other polyhydric phenol compound may be added. Examples of the other polyhydric phenol compound are hydroquinone, resorcinol, phloroglucin, 2,4-dihydroxybenzophenone, trihydroxybenzophenones (e.g. 2,3,4-trihydroxybenzophenone), tetrahydroxybenzophenones (e.g. 2,3,3',4-tetrahydroxybenzophenone, 2,3,4,4'-tetrahydroxybenzophenone, 2,2',4,4'-tetrahydroxybenzophenone), pentahydroxybenzophenones (e.g. 2,2',3,3',4-pentahydroxybenzophenone, 2,3,3',4,5'-pentahydroxybenzophenone), alkyl gallates, bis(mono- or polyhydroxyphenyl)alkanes (e.g. 2,2-bis(2,4-dihydroxyphenyl)propane, etc.), 2-(mono- or polyhydroxyphenyl)-2-(mono- or polyhydroxyphenyl)alkanes(e.g. 2-(3-hydroxyphenyl)-2-(2,5-dihydroxyphenyl)propane), and oxyflavans.

A novolak resin is preferably used as the alkali soluble resin. The novolak resin is prepared by an addition condensation reaction of a phenol with formaldehyde. Specific examples of the phenol used as one of the raw materials for the novolak resin include phenol, cresol, xylenol, ethylphenyl, trimethylphenol, propylphenol, butylphenol, dihydroxybenzene and naphthols. These phenols may be used alone or in combination.

The formaldehyde which undergoes the addition condensation reaction with the phenol can be used in the form of an aqueous solution of formaldehyde (formalin) or paraformaldehyde. In particular, 37 %

formalin which is commercially mass produced is suitably used.

The addition condensation reaction of the phenol with formaldehyde can be carried out according to a usual method. This reaction is carried out at a temperature of 60 to 120 ° C for 2 to 30 hours. Organic acids, inorganic acids or divalent metal salts are used as catalysts. Specific examples of the catalyst are oxalic acid, hydrochloric acid, sulfuric acid, perchloric acid, p-toluenesulfonic acid, trichloroacetic acid, phosphoric acid, formic acid, zinc acetate and magnesium acetate.

The reaction may be carried out in the presence or absence of a solvent.

The amount of the quinone diazide sulfonate to be added to the resist composition is from 10 to 50 % by weight based on the total weight of the solid components in the resist composition.

The positive resist composition is prepared by mixing and dissolving the quinone diazide sulfonate and the alkali-soluble resin in a solvent. Preferably, the used solvent evaporates at a suitable drying rate to give a uniform and smooth coating film. Such solvent includes ethylcellosolve acetate, methylcellosolve acetate, ethylcellosolve, methylcellosolve, propylene glycol monomethyl ether acetate, butyl acetate, methyl isobutyl ketone and xylene.

An amount of the solvent is, for example, from 30 to 80 % by weight in case of ethylcellosolve acetate.

To the positive resist composition obtained by the foregoing method, small amounts of resins, dyes and other usual additives may be added if desired.

The present invention will be illustrate more in detail by the following Examples, but it is not limited to these Examples. In Examples, "parts" are by weight.

Synthesis Example 1

In a 300 ml three-necked flask, 6.96 g of a compound of the formula (III):

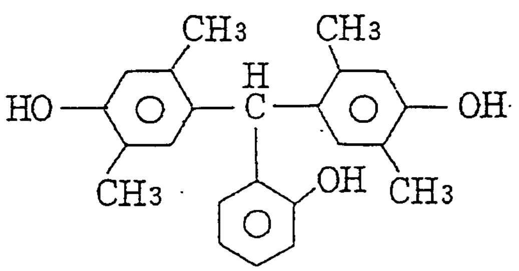

(III)

10.75 g of naphthoquinone-(1,2)-diazide-(2)-5-sulfonyl chloride (a molar ratio of the compound (III) to naphthoquinone-(1,2)-diazide-(2)-5-sulfonyl chloride was 1:2. Hereinafter, a molar ratio is that of a phenol compound to a quinone diazide compound) and 168 g of dioxane were charged and stirred to completely dissolve the compounds. Then, the flask was dipped in a water bath to control a reaction temperature at 20 to 25 ° C, and 4.45 g of triethylamine was dropwise added over 30 minutes while stirring. Thereafter, the reaction mixture was further stirred at 20 to 25 ° C for 4 hours. After the completion of the reaction, the reaction mixture was poured in ion-exchanged water, filtered and then dried to obtain a radiation sensitizer B.

Synthesis Example 2

In the same manner as in Synthesis Example 1 but using the compound of the formula (IV):

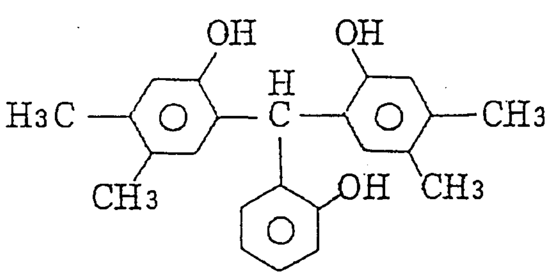

(IV)

in place of the compound (III), a reaction was carried out to obtain a radiation sensitizer C (a molar ratio =

1:2).

Synthesis Example 3

In the same manner as in Synthesis Example 1 but using 2,3,4-trihydroxybenzophenone in place of the compound (III), a reaction was carried out to obtain a radiation sensitizer D (a molar ratio = 1:2).

Synthesis Example 4

In the same manner as in Synthesis Example 1 but using 2,3,4,4'-tetrahydroxybenzophenone in place of the compound (III) and changing a molar ratio to 1:3, a reaction was carried out to obtain a radiation sensitizer E.

Examples 1 and 2 and Comparative Examples 1 and 2

Each of the radiation sensitizers prepared in Synthesis Examples 1 to 4 and the novolak resin A in amounts shown in the Table were dissolved in ethylcellosolve acetate (48 parts) to prepare a resist solution, which was filtered through a TEFLON (a trademark) filter of 0.2 µm in pore size. The resist solution was coated on a silicone wafer, which had been rinsed in a usual way, by means of a spinner so as to form a resist film of 1.3 µm in thickness. Subsequently, the silicon wafer was baked for 60 seconds on a hot plate kept at 100 °C, and exposed to light having a wavelength of 436 nm (g line) while varying the exposure time stepwise by means of a reduction projection exposing apparatus (DSW 4800 with NA of 0.28 manufactured by GCA). Thereafter, the silicon wafer was developed for one minute in a developing solution (SOPD manufactured by Sumitomo Chemical Co., Ltd.) to obtain a positive pattern.

The γ-value is expressed in terms of tan θ the angle θ of which is obtained by plotting the rate of the standardized film thickness (= the retained film thickness/the original film thickness) against the exposure time and calculating the inclination of the plotted line.

The film thickness retention is a ratio (%) of the retained film thickness after development at a film-through exposure amount at a line part (an unexposed part) of a 50 µm line-and-space pattern to the original film thickness.

The results are shown in the Table.

Table

| Example No. | Composition | | Film thickness retention (%) | γ-value |
|---|---|---|---|---|
| | Novolak*1) resin A | Radiation sensitizer | | |
| 1 | 17 parts | B: 5 parts | 99 | 3.2 |
| 2 | 17 parts | C: 5 parts | 98 | 4.3 |
| Comp. 1 | 17 parts | D: 5 Parts | 90 | 2.2 |
| Comp. 2 | 17 parts | E: 5 parts | 94 | 2.0 |

Note: *1) Novolak resin A: A cresol mixture (a molar ratio of m-isomer to p-isomer = 4:6) was reacted with formalin (a molar ratio of the cresols to formalin = 1:0.8) using oxalic acid as a catalyst under reflux to obtain a novolak resin having a weight average molecular weight of 4200 (calculated as polystyrene).

The positive resist composition of the present invention has the excellent properties such as a high γ-value, a high film thickness retention, and a decreased residue after developing.

**Claims**

**1.** A positive resist composition which comprises, in admixture, an alkali-soluble resin and at least one quinone diazide sulfonate of a phenol compound of the formula:

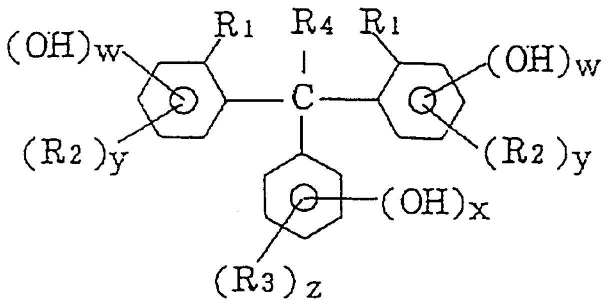

(I)

wherein $R_1$ and $R_2$ are independently an alkyl group, an alkoxy group, a carboxyl group or a halogen atom; $R_3$ is a hydrogen atom, an alkyl group, an alkoxy group, a carboxyl group or a halogen atom; $R_4$ is a hydrogen atom, an alkyl group or an aryl group; and w, x, y and z are independently 0, 1, 2 or 3, provided that the sum of w and x is at least 1.

**2.** The positive resist composition according to claim 1, wherein $R_1$ and $R_2$ are independently a $C_1$-$C_5$ alkyl group, a methoxy group, an ethoxy group or a carboxyl group; $R_3$ is a hydrogen atom, a $C_1$-$C_5$ alkyl group, a methoxy group, an ethoxy group or a carboxyl group; and $R_4$ is a hydrogen atom, a $C_1$-$C_5$ alkyl group or an aryl group.

**3.** The positive resist composition according to claim 1, wherein the phenol compound is a compound of the formula:

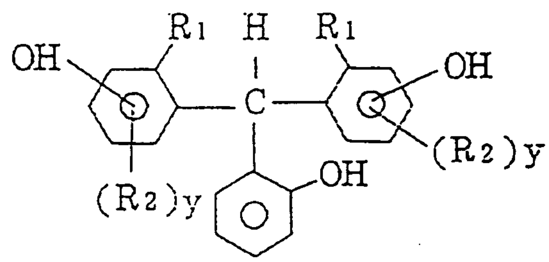

wherein $R_1$, $R_2$ and y are the same as defined above.

**4.** The positive resist composition according to claim 1, wherein the phenol compound is a compound of the formula:

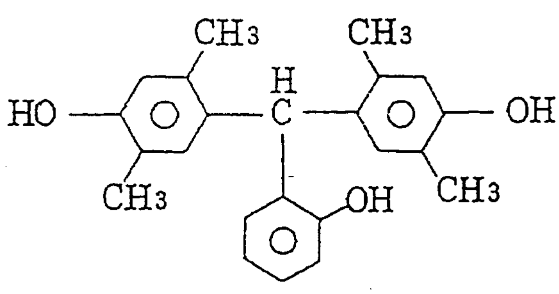

**5.** A positive resist composition which comprises, in admixture, an alkali-soluble resin and at least one quinone diazide sulfonate of a phenol compound of the formula:

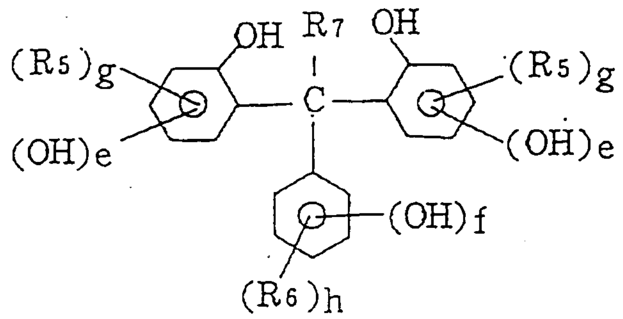

(II)

wherein $R_5$ is an alkyl group, an alkoxy group, a carboxyl group or a halogen atom; $R_6$ is a hydrogen atom, an alkyl group, an alkoxy group, a carboxyl group or a halogen atom; $R_7$ is a hydrogen atom, an alkyl group or an aryl group; and e, f, g and h are independently 0, 1, 2 or 3.

**6.** The positive resist composition according to claim 5, wherein $R_5$ is a $C_1$-$C_5$ alkyl group, a methoxy group, an ethoxy group or a carboxyl group; $R_6$ is a hydrogen atom, a $C_1$-$C_5$ alkyl group, a methoxy group, an ethoxy group or a carboxyl group; and $R_7$ is a hydrogen atom, a $C_1$-$C_5$ alkyl group or an aryl group.

**7.** The positive resist composition according to claim 5, wherein the phenol compound is a compound of the formula:

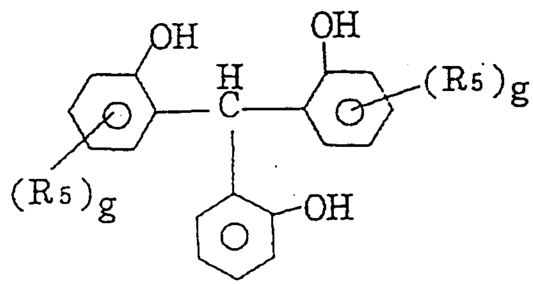

wherein $R_5$ and g are the same as defined above.

**8.** The positive resist composition according to claim 5, wherein the phenol compound is a compound of the formula:

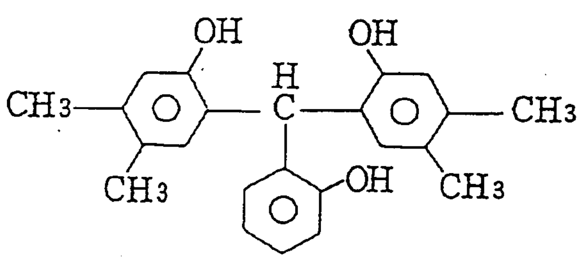

European Patent Office

# EUROPEAN SEARCH REPORT

Application Number

EP 92 10 4167

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | PATENT ABSTRACTS OF JAPAN<br>vol. 13, no. 478 (P-951)(3826) 30 October 1989<br>& JP-A-1 189 644 ( FUJI PHOTO FILM COMPANY ) 28 July 1989<br>* abstract *<br>--- | 1-8 | G03F7/022 |
| Y | EP-A-0 358 871 (SUMITOMO CHEMICAL COMPANY)<br>* page 8, line 1 - line 49; claims *<br>--- | 1-8 | |
| A | EP-A-0 384 481 (CHISSO CORPORATION)<br>* examples *<br>--- | 1-8 | |
| P,X | EP-A-0 430 477 (NIPPON ZEON CO.)<br>* claims; examples *<br>----- | 1-7 | |

TECHNICAL FIELDS SEARCHED (Int. Cl.5 )

G03F

The present search report has been drawn up for all claims

| Place of search | Date of completion of the search | Examiner |
|---|---|---|
| BERLIN | 24 JUNE 1992 | STOCK H. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)